# EUROPEAN PATENT APPLICATION

(11) **EP 0 722 198 A2**
(43) Date of publication of application: **17.07.1996**
(21) Application number: 96300124.3
(22) Date of filing: 08.01.1996
(51) Int. Cl.: H01R 4/62

(54) **Bonding wire with integral connection**

(30) Priority: 10.01.1995 US 370706
(71) Applicant: TEXAS INSTRUMENTS INC., Dallas, Texas 75243 (US)
(72) Inventor: Vinson, Michael R., Lansdale, Pennsylvania 19446 (US)
(74) Representative: Holt, Michael

(57) **Abstract**

A wire for use in making connection to bond pads of semiconductor devices and the like, the interconnection and method of making the interconnection between a semiconductor device or the like and an external connection point with a plated (3) wire (1) which can have one or more different layers of plating thereon. When the core material (1) will be the electrical conductor (skin effect is not present), the core material will be highly electrically conductive, such as aluminum, copper, silver or gold with the particular material used be chosen to be compatible with the bond pad to which connection is to be made. The outer plating material is chosen to be both electrically conductive and compatible with the material of the external connection point and also capable of forming an alloy with the core material which is compatible with the bond pad. Nickel and palladium, for example, are appropriate plating materials. When two plating layers are used, the intermediate layer (3) will generally provide an alloy with the wire material and the outer layer (5) which is better compatible with the bond pad material than the core material and outer layer alone. In the case of high frequency operation (skin effect is present), the core need not be a good electrical conductor whereas the plating thereon must be a good electrical conductor. Otherwise, the requirements for bonding are the same. In general, the properties of the core material and the plating material can be tailored to each other to enhance the total overall properties of the conductor for the required end use.

## Description

### FIELD OF THE INVENTION

This invention relates to electrical wire and interconnects made therewith and, more specifically, to wire for use in making connection to bond pads of semiconductor devices and the like, the interconnection and method of making the interconnection.

### BRIEF DESCRIPTION OF THE PRIOR ART

The electrical interconnection of electronic devices is currently generally accomplished by thermosonic welding of a gold wire to a pad on a die of a semiconductor device and to a lead of a lead frame, the semiconductor device and a portion of the lead frame then being encapsulated in plastic. To achieve good bonding at the electrical connections at both ends of the wire, the device must be heated to a temperature above 240°C.

Ball bonding is a well known interconnect method wherein one end of an interconnect is connected to a pad on a semiconductor device and involves heating one end of an interconnect wire, generally gold, to form a ball at that end of the wire. The wire with the ball at one end is then threaded through a capillary and welded to the surface of the bond pad on the semiconductor device, generally by thermosonic welding. The other end of the wire is then forced or crushed against a lead frame or the like by the capillary and connection at the other end of the wire is then made, also generally by thermosonic welding. This is the most rapid technique presently available because no distinction is required as to the order of the connections. Therefore no change in the orientation of the work or the tool is required in order to make the connections.

Due to the increased miniaturization of semiconductor devices in conjunction with the large die sizes being utilized, it is necessary to reduce the temperature at which wire bonding takes place as well as to reduce the area or geometry of the interconnects themselves due to the required reduction in pad dimensions on the increasingly miniaturized semiconductor devices. This is because, with a large number of I/Os, heat can cause the die/leadframe to expand at different rates and crack the adhesive therebetween. This increased miniaturization makes the present ball bonding technique very difficult to handle. In addition, it is often necessary to provide a wire having different chemical properties at opposing ends thereof because the chemistry at the two connection locations differs, this causing a problem with the use of prior art wires. It follows that present ball bonding techniques are not compatible with the new generations of miniaturized semiconductor devices.

### SUMMARY OF THE INVENTION

If ball bonding is to be used in conjunction with further miniaturization of components, a smaller ball must be provided with a very small bond at the end of the wire opposed to the ball end, this being preferably accomplished at a very low temperature, essentially about 20°C., though this temperature is not critical. From a process standpoint, room temperature operation is valuable because it eliminates the requirement for a heater and the associated controls. Most processes will allow for some heat varying from about 60 to about 350°C. The next most desirable temperature would be about 175°C because most devices are exposed to at least this temperature outside of the bond process. The present method will lower bonding temperatures because the two materials to be bonded will be more compatible than in the prior art, therefore requiring less time-temperature-pressure. Since the bond requires pressure which increases the size of the bond, the present procedure also reduces bond size.

A further problem that arises is that the material to which the bond is made at the ball side may be different from the material to which the bond is made at the other wire end. It is therefore apparent that it is necessary to have a wire which has different properties at opposing ends, these properties matching the properties required for bonding to the associated bonding regions.

In accordance with the present invention, there is provided a process that does not require heat above ambient (about 20°C) so that heat sensitive packages can be interconnected at the high productivity rates of a ball bonder on currently available equipment. Since the metal on the die and the metal on the lead frame are generally different, it has been impossible to find a single material that can be used effectively without presenting some problems due to the materials including chemical mismatch (atomic size, crystal structure, size, chemical bonding properties, etc.), this problem also being overcome in accordance with the present invention.

Briefly, the problems encountered by the prior art are overcome by providing a wire which can provide different properties at opposing ends thereof. In accordance with a first embodiment, a metal wire or core is plated with a metal different from the core material. The composite alloy material formed at the ball during ball formation is composed of the material of the wire and the plating thereon with the material of the pad possibly being added to the alloy as an additional embodiment. The metal wire and plating material are selected so that the alloy formed at the ball provides a good electrical connection at the pad and the plating itself provides a good electrical connection with the surface to which the wire is to be connected at the opposing end of the wire. In this manner, optimized characteristics are provided at both ends of the wire interconnection.

In operation, the first bond on a die pad is formed by melting one end of the plated wire to form a ball of an alloy of the core and plating or homogenous mixture of the core and plating, as the case may be. The ball is then seated into a capillary in standard manner and attached to the die pad metal in standard manner, such as by ultrasonics or the like, with the formation of an alloy at the pad composed of the ball and possibly some material from the die pad which have diffused into each other. The material of the die pad may be the same as the plating or the wire or merely compatible with the material of the ball. By melting the wire, the plating will mix somewhat with the core material and take on more of the core material characteristics. The second bond is formed by directly smashing the wire to the lead material with the capillary as in the prior art and then bonding the wire to the lead material ultrasonically. The plating is then the primary contact material. Different core and plating materials can be used, depending upon the characteristics of the die pad and the lead materials.

Another advantage that plating provides is in retarding corrosion, especially if the core wire is susceptible to corrosion and/or oxidation. In the case of, for example, aluminum wire plated with nickel, once encapsulated in plastic, the wire would be shielded by the nickel. The ball forming process, provided by heating the wire to melting causes corrosion when heated in an oxygen (normal air) environment. Metals such as aluminum and magnesium can actually burn. Plating retards this type of corrosion during the processing as well as at other times by providing a shield around the core material. For this reason, some core materials that would otherwise be rejected, such as silver and possibly pure aluminum are protected against oxidation and/or corrosion by the plating thereon and can be used.

High frequency devices will show enhanced performance if the plating material is highly conductive since the current flow is on the surface of the conductor due to skin effect. While plated wire is not new, the use of plated wire in the interconnection of semiconductor devices is not currently used.

In summary, there is provided a wire for use in making connection to bond pads of semiconductor devices and the like, the interconnection and method of making the interconnection between a semiconductor device or the like and an external connection point with a plated wire which can have one or more different layers of plating thereon. When the core material will be the electrical conductor (skin effect is not present), the core material will be highly electrically conductive, such as aluminum, copper, silver or gold with the particular material used being chosen to be compatible with the bond pad to which connection is to be made. The outer plating material is chosen to be both electrically conductive and compatible with the material of the external connection point and also capable of forming an alloy with the core material which is compatible with the bond pad. Nickel and palladium, for example, are appropriate plating materials. When two plating layers are used, the intermediate layer will generally provide an alloy with the wire material and the outer layer will be more compatible with the bond pad material than the core material. The intermediate layer can also be used to provide other desirable properties such as attaching the outer layer to the inner layer. In the case of high frequency operation where skin effect is present, the core need not be a good electrical conductor whereas the plating thereon must be a good electrical conductor. Otherwise, the requirements for bonding are the same. In general, the properties of the core material and the plating material can be tailored to each other to enhance the total overall properties of the conductor for the required end use.

While the term "plating" has been used to describe the coating layer or layers on the core, it should be understood that the layer can be formed on the core by any known technology, the invention herein not being limited to the process of plating. It is merely necessary that the layer be somehow clad onto the core.

Some examples of wire that can be used in accordance with the present invention are Al/Pt, Al/Pd, Al/Ni, Cu/Al, Cu/Ni, Cu/Pd, Al/Ni/Pd and Cu/Ni/Pd. The dimensions of the layer relative to the core for a one layer wire are typically <50 percent of total cross section and for a core with two layers would be typically <60 percent of total cross section.

In accordance with a second embodiment, the wire is initially a homogeneous mixture of at least two metals, such as, but not limited to Cu/Al, Cu/Mg, Cu/Be/Li and a getter for oxygen if one of the metals is not already a getter for oxygen, preferably copper and aluminum (aluminum is a getter for oxygen) of which at least one of the elements can be transformed, such as by oxidation/reduction type reaction, to create a zone of new alloy composition surrounding the original homogeneous composition.

This process is similar to one used to produce superconducting alloys and the supporting casing. The reaction can either create a dispersion of fine particles with the reacting elements, such as oxide or nitride particles, or the reaction can deplete the alloy of the reacting elements in the zone. An example of a dispersion is a Cu/Li alloy of 90 atomic percent Cu and 10 atomic percent Li. By partially diffusing the alloy with oxygen, a purer form of copper would remain as a good conductor in the outer/diffused region, while the core would retain the properties of the alloy. An example of depletion of the alloy would be brass (Cu 70%, Zn 30%), where the Zn could be removed from the Cu by acid bath. The amounts of each of the elements present in the wire is not critical and merely need be sufficient to provide the required properties as discussed herein.

Oxygen is then diffused into a region extending partially into the wire. Upon heating, the oxygen purifies the copper and also oxidizes the aluminum into aluminum oxide at the surface regions. The copper retains interconnecting porosity at the surface regions and is highly conductive whereas the central portion of the wire contains two highly conductive metals and is also highly electrically conductive. The result is a single metal on the exterior of the wire with aluminum oxide dispersed therethrough and the homogenous starting mixture at the core. An advantage of this wire is that it can be connected in standard manner using a capillary in ambient atmosphere rather than in a forming gas atmosphere as is otherwise required. Also, no cladding step is required.

### BRIEF DESCRIPTION OF THE DRAWING

FIGURE 1 is a cross section of a composite wire with one layer of metal thereon as used in accordance with the present invention;
FIGURE 2 is a cross section of a composite wire with two layers of metal thereon as used in accordance with the present invention; and
FIGURE 3 is a cross section of a wire wherein the layers are formed by chemical action from a homogeneous core in accordance with another embodiment of the invention.

### DESCRIPTION OF THE PREFERRED EMBODIMENT

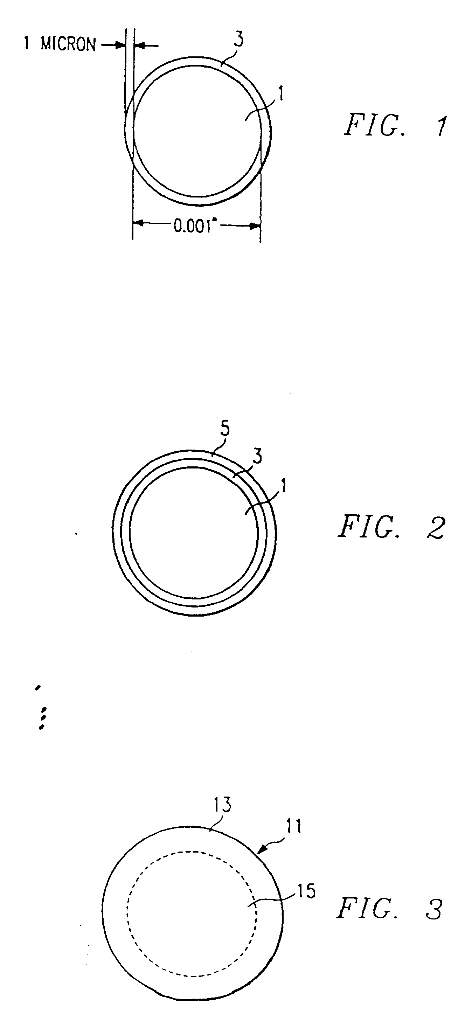

Referring now to FIGURE 1, there is shown a wire as used in accordance with a first embodiment of the present invention. The wire includes a core of electrically conductive material 1, the core shown to be aluminum and having a diameter of 0.001 inch with a plating 3 thereon which is shown to be nickel and have a thickness of 1 micron. When a wire of the type shown in the FIGURE is heated to form a ball, the resulting mixture in the ball is about 60% aluminum and 40% nickel by weight. The ball would generally be bonded in standard manner to an aluminum pad whereas the opposing end of the wire would be bonded by smashing in standard manner to the lead frame material. The nickel plating would be the primary contact material and would generally be smashed against a palladium plated lead.

Referring now to FIGURE 2, there is shown a wire which is the same as that of FIGURE 1 except that an additional layer 5 of palladium has been added. In operation, since the outer layer is palladium, this material will be even more compatible with a palladium coated lead frame than the nickel of FIGURE 1. Otherwise, the operation is the same with the alloy at the ball containing some palladium in addition to the nickel. In this embodiment, the thickness of the nickel layer can be reduced somewhat relative to that of FIGURE 1 with the palladium layer having a thickness about half that of the nickel layer. As an example, for a 25 micron aluminum core, a nickel layer thereon would be about 0.1 micron and a palladium layer thereon would be about 0.05 micron.

Referring now to FIGURE 3, there is shown a further embodiment of a wire that can be used in accordance with the present invention. The wire 11 is composed of copper which initially had 3% by weight lithium homogeneously dispersed therethrough. Oxygen is then diffused from about 1% to about 50% (a thin layer being preferred for high frequency) into the wire in the region denoted as 13 and heated. The result is that the lithium in the region 13 is reduced to lithium oxide with the lithium acting as a getter for impurities. The region 13 is highly electrically conductive because the lithium oxide that forms has interconnecting porosity with the copper filling the space not occupied by the lithium oxide. The central portion 15 of the wire, whereat the oxygen does not diffuse, remains as a homogeneous mixture of copper and lithium and is highly electrically conductive. It follows that a ball can be formed at one end of the wire consisting essentially of copper, lithium and some lithium oxide whereas the opposite end of the wire contains mostly copper which is compatible with a copper lead frame.

Though the invention has been described with respect to a specific preferred embodiment thereof, many variations and modifications will immediately become apparent to those skilled in the art. It is therefore the intention that the appended claims be interpreted as broadly as possible in view of the prior art to include all such variations and modification.

## Claims

1. A composite wire for making electrical interconnections comprising:
(a) a metal core; and
(b) a metal-containing region surrounding said core of material other than the material of said core, capable of forming a ball at one end of said wire consisting essentially of a mixture of the material of said core and the material of said region, said mixture being electrically compatible with a predetermined pad material and said region being electrically compatible with a predetermined lead material different from said pad material.

2. The wire of claim 1 wherein said core is one of copper or aluminum and said region is one of platinum, palladium, nickel or palladium coated on nickel when said core is aluminum and said region is one of aluminum, nickel, palladium or palladium coated on nickel when said core is copper.

3. The wire of claim 1 wherein said core is more highly electrically conductive than said region.

4. The wire of claim 1 wherein said region is more highly electrically conductive than said core.

5. The wire of claim 1 wherein said core is a mixture of copper and lithium and said region is a mixture of copper and lithium oxide.

6. An method of forming an electrical connection comprising the steps of:
(a) providing a first region of a first material and a second region of a material different from said first material to which electrical interconnection is to be made;
(b) providing a metal core;
(c) providing a metal-containing region surrounding said core of material other than the material of said core, capable of forming a ball at one end of said wire, consisting essentially of a mixture of the material of said core and the material of said region, said mixture being electrically compatible with said first material at said first region and said region being electrically compatible with said material at said second region;
(d) forming said ball; and
(e) securing said ball to said first region.

7. The method of claim 6 further including the step of securing said region at the end of said wire remote from said ball to said second region.

8. The method of claim 6 wherein said core is one of copper or aluminum and said region is one of platinum, palladium, nickel or palladium coated on nickel when said core is aluminum and said region is one of aluminum, nickel, palladium or palladium coated on nickel when said core is copper.

9. The method of claim 6 wherein said core is more highly electrically conductive than said region.

10. The method of claim 6 wherein said region is more highly electrically conductive than said core.

11. The method of claim 7 wherein said core is one of copper or aluminum and said region is one of platinum, palladium, nickel or palladium coated on nickel when said core is aluminum and said region is one of aluminum, nickel, palladium or palladium coated on nickel when said core is copper.

12. The method of claim 7 wherein said core is more highly electrically conductive than said region.

13. The method of claim 7 wherein said region is more highly electrically conductive than said core.

14. The method of claim 7 wherein said core is a mixture of copper and lithium and said region is a mixture of copper and lithium oxide.

15. An electrical connection which comprises:
(a) a first region of a first material and a second region of a material different from said first material to which electrical interconnection is to be made;
(b) a wire comprising a ball at one end thereof, said wire including:
(i) a metal core; and
(ii) a metal region surrounding said core of a material other than the material of said core, forming said ball consisting essentially of a mixture of the material of said core and the material of said region, said mixture being electrically compatible with the material of said first region and said region being electrically compatible with the material of said second region; and
(d) electrical connection between said ball and said first region.

16. The connection of claim 15 further including an electrical connection between said region at the end of said wire remote from said ball to said second region.

17. The connection of claim 15 wherein said core is one of copper or aluminum and said region is one of platinum, palladium, nickel or palladium coated on nickel when said core is aluminum and said region is one of aluminum, nickel, palladium or palladium coated on nickel when said core is copper.

18. The connection of claim 15 wherein said core is more highly electrically conductive than said layer.

19. The connection of claim 15 wherein said layer is more highly electrically conductive than said core.

20. The connection of claim 16 wherein said core is one of copper or aluminum and said region is one of platinum, palladium, nickel or palladium coated on nickel when said core is aluminum and said region is one of aluminum, nickel, palladium or palladium coated on nickel when said core is copper.

21. The connection of claim 16 wherein said core is more highly electrically conductive than said region.

22. The connection of claim 16 wherein said region is more highly electrically conductive than said core.

23. The connection of claim 16 wherein said core is a mixture of copper and lithium and said region is a mixture of copper and lithium oxide.

24. A semi-conductor device including connection wire as claimed in any of claims 1 to 5, or a connection as claimed in any of claims 15 to 23 or formed by the method of any of claims 6 to 14.
